# FASCICULE DE BREVET EUROPEEN

(11) **EP 3 729 612 B1**
(45) Date de publication et mention de la délivrance du brevet: **03.09.2025**
(21) Numéro de dépôt: 18822359.8
(22) Date de dépôt: 20.12.2018
(51) Int. Cl.: H02K 9/02, H02K 11/04, H02K 11/33

(54) **SYSTEME DE CONTROLE D'UNE MACHINE ELECTRIQUE TOURNANTE**
STEUERUNGSSYSTEM FÜR EINE ROTIERENDE ELEKTRISCHE MASCHINE
CONTROL SYSTEM FOR A ROTATING ELECTRICAL MACHINE

(30) Priorité: 22.12.2017 FR 1763071
(43) Date de publication de la demande: 28.10.2020
(73) Titulaire: Valeo Electrification, 95800 Cergy (FR)
(72) Inventeur: BAUDESSON, Philippe, 95892 CERGY PONTOISE (FR); BODIN, Ludovic, 94046 CRETEIL CEDEX (FR); HENNEGUET, Romain, 94046 CRETEIL CEDEX (FR)
(74) Mandataire: Valeo Powertrain Systems
(86) Numéro de dépôt international: PCT/EP2018/086180
(87) Numéro de publication internationale: WO 2019/122117

(56) Documents cités:
- EP-A1- 3 176 918
- WO-A1-2017/175343
- FR-A1- 3 010 590
- US-A1- 2012 098 361
- US-A1- 2017 349 206

## Description

### Domaine technique

La présente invention a trait à la gestion de la température d'un système de contrôle d'une machine électrique tournante, notamment d'un véhicule automobile. En particulier, l'invention concerne notamment un système de contrôle d'une machine électrique tournante.

### État de la technique antérieure

Une machine électrique tournante est un dispositif électromécanique, préférentiellement polyphasé, et permettant de convertir une énergie électrique en une énergie mécanique, ou inversement. Une application connue des machines électriques tournantes dans le domaine de l'automobile est l'alterno-démarreur : un dispositif d'arrêt et de redémarrage automatique d'un moteur thermique de véhicule automobile qui permet de réduire la consommation en carburant et la pollution, par exemple lors d'un arrêt de courte durée à un feux rouge.

Lors d'un redémarrage du véhicule automobile, suite à son arrêt temporaire au cours duquel le moteur thermique avait été coupé, la machine électrique tournante est utilisée comme moteur afin de produire l'énergie mécanique à partir de l'énergie électrique et d'entrainer en rotation le moteur thermique afin de le faire redémarrer.

De manière connue, la machine électrique tournante est pilotée par un système de contrôle. Plus particulièrement, le système de contrôle comprend un boitier logeant un module de puissance permettant de définir une valeur d'un courant électrique circulant dans chacune des phases électriques d'un stator de ladite machine électrique tournante, et un module de commande permettant de piloter le module de puissance en fonction de certains paramètres environnementaux et données mesurée sur le véhicule automobile.

Du fait de la présence de nombreux composants électronique, et notamment des composants de puissance et des capacités de filtrage, le système de contrôle produit de nombreuses calories, principalement par effet Joules, durant son fonctionnement. Afin de garantir un fonctionnement optimal d'une part et d'éviter un dysfonctionnement et/ou des pannes prématurées du module de commande ou de la machine électrique tournante, il est connu d'associer au système de contrôle un ou plusieurs dissipateurs thermiques afin de dissiper les calories générées durant son fonctionnement tels que décrits dans les demandes de brevet US2012/098361 et US3176918.

Ainsi, on connait des systèmes de contrôle dont le boitier loge aussi plusieurs dissipateurs thermiques afin de favoriser les échanges thermiques entre d'une part l'air mis en mouvement par la machine électrique tournante, et d'autre part le module de commande et le module de puissance. En particulier, le refroidissement des capacités de filtrage associées au module de puissance est délicat à mettre en œuvre ; et il est connu d'associer à ces capacités de filtrage un dissipateur spécifique situé au niveau d'un couvercle de fermeture du système de contrôle, en contact thermique avec une extrémité desdites capacités de filtrage. Malheureusement, les performances thermiques du dissipateur thermique associé aux capacités de filtrage restent insuffisantes. Il en résulte une élévation de température au niveau des capacités de filtrages qui contribue à diminuer l'efficience et la disponibilité du système de contrôle.

Un but de la présente invention est de de proposer un nouveau système de contrôle pour machine électrique tournante afin de répondre au moins en grande partie aux problèmes précédents et de conduire en outre à d'autres avantages.

En particulier, un autre but de la présente invention est de refroidir plus efficacement les capacités de filtrage du système de contrôle.

### Exposé de l'invention

Selon un premier aspect de l'invention, on atteint au moins l'un des objectifs précités avec un système de contrôle comprenant :
- un module de puissance connecté électriquement à une machine électrique tournante;
- un module de commande configuré pour générer au moins un signal de commande permettant de piloter le module de puissance, ledit module de commande étant logé dans un boitier;
- un premier dissipateur thermique associé au module de puissance, ledit premier dissipateur thermique étant configuré pour réaliser un transfert thermique des calories générées par le module de puissance durant son fonctionnement avec un air ambiant ;
- un deuxième dissipateur thermique associé au module de commande, ledit deuxième dissipateur thermique étant configuré pour réaliser un transfert thermique des calories générées par le module de commande durant son fonctionnement avec l'air ambiant ;
- au moins une capacité de filtrage électriquement reliée au module de puissance, et insérée entre ledit premier dissipateur thermique et ledit deuxième dissipateur thermique;
   comprenant également au moins une entretoise s'étendant entre le premier dissipateur thermique et le deuxième dissipateur thermique,
   et le module de puissance est situé au-dessus du premier dissipateur thermique, de sorte que ledit module de puissance se trouve dans une position axialement intermédiaire entre le premier dissipateur thermique et le deuxième dissipateur thermique, par rapport à un axe de rotation O,
   et le deuxième dissipateur thermique comprend au moins un logement configuré pour loger en partie au moins une capacité de filtrage et qui permet de coupler thermiquement le deuxième dissipateur thermique et la capacité de filtrage afin de réaliser un transfert thermique des calories générées par ladite au moins une capacité de filtrage avec l'air ambiant.

Le système de contrôle est connecté électriquement à la machine électrique tournante afin de pouvoir générer au moins un signal électrique de puissance destiné à alimenter une phase électrique d'un stator d'une machine électrique tournante.

Dans un mode de réalisation de l'invention, le système de contrôle est également connecté à un réseau électrique, notamment un réseau de bord d'un véhicule automobile. Un réseau de bord sert à alimenter différents équipements électriques équipant ledit véhicule automobile. Une alimentation électrique du réseau de bord est fournie par au moins une batterie qui peut être rechargée, lorsque le véhicule automobile est en mouvement, par la machine électrique tournante qui convertit alors une énergie mécanique de rotation du moteur thermique en une énergie électrique qui est fournie au réseau et/ou à l'au moins une batterie.

De manière avantageuse, le module de commande peut prendre la forme d'une carte électronique formée par un substrat sur lequel sont fixés solidairement des composants électroniques reliés électriquement entre eux par des pistes électriques, formant ainsi un circuit électrique pour générer un ou plusieurs signaux de commande permettant à leur tour de piloter le module de puissance. Le module de commande permet d'interpréter une pluralité de signaux électriques provenant d'un réseau électrique du véhicule automobile et/ou de capteurs. Le réseau électrique et/ou les capteurs permettent de rendre compte du fonctionnement du véhicule automobile et/ou d'un environnement dans lequel celui-ci évolue. Parmi ses composants électroniques, le module de commande comprend avantageusement au moins un circuit intégré ou un microprocesseur ou un contrôleur afin de réaliser des opérations complexes et de générer un ou plusieurs signaux électriques de commande qui permettent de piloter un état électrique du module de puissance. À titre d'exemple non limitatif, le substrat du module de commande prend avantageusement la forme d'une carte PCB (acronyme anglais pour « Printed Circuit Board », circuit imprimé).

Selon l'invention conforme à son premier aspect, le deuxième dissipateur thermique est couplé thermiquement avec la ou les capacités de filtrage afin de réaliser un échange thermique essentiellement par conduction thermique entre ladite ou lesdites capacités de filtrage et ledit deuxième dissipateur thermique.

En outre, dans un mode particulier de réalisation de l'invention, le deuxième dissipateur thermique est couplé thermiquement avec le module de commande afin de réaliser un échange thermique essentiellement par conduction thermique entre ledit module de commande et ledit deuxième dissipateur thermique.

De manière comparable, le module de puissance prend avantageusement la forme d'au moins un organe de puissance, chaque organe de puissance étant formée par un substrat sur lequel sont fixés solidairement des composants électroniques reliés électriquement entre eux, formant ainsi un circuit électrique pour piloter la machine électrique tournante. Le module de puissance est relié électriquement à la machine électrique tournante par l'intermédiaire d'un bus-barre permettant de transférer des signaux électriques de puissance entre les composants électroniques et la machine électrique tournante.

Lorsque la machine électrique tournante est utilisée comme générateur électrique, le module de puissance, en fonction des signaux électriques de commande générés par le module de commande, permet de générer le ou les signaux électriques de puissance destinés à alimenter chacune des phases électriques du stator de la machine électrique tournante, afin de l'entrainer en rotation. À cet effet, le module de puissance comprend des composants de puissance, tels que des transistors de puissances, par exemple du type MOSFET (acronyme anglais pour « Metal-Oxyde Semiconductor Field-Effect Transistor », transistor à effet de champ à grille métal-oxyde) et qui sont avantageusement pilotés en commutation. En particulier, le module de puissance forme avantageusement un pont formé par une pluralité de paires de transistors de puissance, chaque paire de transistor de puissance étant reliée électriquement à l'une des phases électriques de la machine électrique tournante. À titre d'exemple non limitatif, selon un mode préféré de l'invention conforme à son premier aspect, le module de puissance prend la forme d'une pluralité d'organes de puissance, et préférentiellement encore trois organes de puissance, chaque organe de puissance étant associé à deux phases électriques de la machine électrique tournante.

Selon une forme particulièrement avantageuse de réalisation, chaque organe de puissance prend la forme d'au moins un substrat métallique, tel que par exemple un barreau de cuivre, sur lequel les composants électroniques sont fixés solidairement, par exemple par soudage. Chaque substrat métallique est surmoulé par un matériau isolant électriquement qui entoure tous les composants électroniques.

Selon l'invention conforme à son premier aspect, le premier dissipateur thermique est couplé thermiquement avec le module de puissance afin de permettre un échange thermique essentiellement par conduction thermique entre ledit module de puissance et ledit premier dissipateur thermique. Plus particulièrement, chaque organe de puissance est associé à au moins une partie du premier dissipateur thermique, de sorte que chaque organe de puissance soit couplé thermiquement avec le premier dissipateur thermique.

Dans le système de contrôle conforme au premier aspect de l'invention, la ou les capacités de filtrage s'étendent au moins en partie entre le module de commande et le module de puissance. En d'autres termes, la ou les capacités de filtrage sont situées dans une position intermédiaire entre le module de puissance et le module de commande, par rapport à une direction sensiblement perpendiculaire à un surface d'appui du module de commande contre le deuxième dissipateur thermique.

La ou les capacités de filtrages sont électriquement reliées au module de puissance, et notamment aux transistors de puissance dudit module de puissance. En particulier, chaque organe de puissance est relié électriquement à au moins une capacité de filtrage.

Avantageusement, dans un mode particulier de réalisation de l'invention, le système de contrôle conforme au premier aspect de l'invention comprend cinq capacités de filtrage.

Conformément à son premier aspect, l'invention permet d'améliorer l'efficacité des transferts thermiques entre la ou les capacités de filtrage et le deuxième dissipateur thermique car ledit deuxième dissipateur thermique est en couplage thermique avec le module de commande et la ou les capacités de filtrage, simultanément. Cette disposition avantageuse est particulièrement intéressante et efficace lorsque le système de contrôle est associé à la machine électrique tournante avec laquelle il est destiné à être utilisé, comme il sera décrit ultérieurement en référence au deuxième aspect de l'invention.

Le système de contrôle conforme au premier aspect de l'invention peut comprendre avantageusement au moins un des perfectionnements ci-dessous, les caractéristiques techniques formant ces perfectionnements pouvant être prises seules ou en combinaison :
- le module de puissance est connecté à un réseau électrique, par exemple à un réseau de bord ;
- ladite au moins une capacité de filtrage permet de filtrer le courant échangé entre ledit module de puissance et le réseau de bord ;
- un filtre en pi est placé entre le module de puissance et le réseau de bord, ledit filtre en pi comprenant ladite au moins une capacité de filtrage ;
- le premier dissipateur thermique et/ou le deuxième dissipateur thermique sont avantageusement réalisé dans un matériau possédant un coefficient de conduction thermique élevé afin de favoriser les transferts thermiques par conduction et d'améliorer l'efficacité du premier et/ou du deuxième dissipateur thermique. Préférentiellement, le matériau est métallique, et comprend par exemple de l'aluminium ou un alliage d'aluminium ;
- chaque au moins une capacité de filtrage comprend une face de dissipation en contact thermique avec une face de couplage thermique du deuxième dissipateur thermique et située en regard de ladite face de dissipation. Éventuellement, une partie seulement des capacités de filtrage comprennent chacune une face de dissipation en contact thermique avec une face de couplage thermique du deuxième dissipateur thermique située en regard de ladite face de dissipation. Cette configuration avantageuse permet d'améliorer le transfert de calories entre la capacité de filtrage correspondante et le dissipateur thermique. De manière avantageuse, la face de dissipation des capacités de filtrage est un flasque de fermeture desdites capacités de filtrage ;
- la face de dissipation de chaque au moins une capacité de filtrage est en contact thermique avec le deuxième dissipateur thermique par l'intermédiaire d'un élément conducteur thermique. Cette configuration avantageuse permet d'améliorer le transfert de calories entre la capacité de filtrage correspondante et le dissipateur thermique. À titre d'exemple non limitatif, l'élément conducteur thermique est du type d'une colle thermique ;
- le deuxième dissipateur thermique comprend une plaque de base dont une première face d'échange thermique est en contact thermique avec au moins une partie des composants électroniques du module de commande, et une deuxième face d'échange thermique comprend une pluralité d'ailettes qui s'étendent en saillie par rapport à ladite deuxième face d'échange thermique et dans une direction opposée à la première face d'échange par rapport à la deuxième face d'échange thermique. Le contact thermique de la première face d'échange thermique de la plaque de base avec le module de commande permet de réaliser un couplage thermique entre une partie des composants électronique et le deuxième dissipateur thermique et de dissiper les calories produites par les composants électroniques durant leur fonctionnement vers le deuxième dissipateur thermique. La présence des ailettes sur la deuxième face d'échange thermique de la plaque de base permet d'augmenter la surface d'échange thermique entre le deuxième dissipateur thermique et l'air ambiant. Cette configuration avantageuse permet d'améliorer les échanges thermiques entre le module de commande et l'air ambiant ;
- dans un plan parallèle à la deuxième face d'échange thermique, chaque ailette du deuxième dissipateur thermique s'étend longitudinalement selon une direction radiale par rapport à un axe central du système de contrôle, ledit axe central s'étendant perpendiculairement à la deuxième face d'échange thermique. Cette configuration avantageuse permet notamment de générer une pluralité de canaux permettant de guider l'air ambiant depuis l'extérieur du deuxième dissipateur thermique en direction de l'axe central du système de contrôle, favorisant encore davantage les échanges thermiques en créant un flux d'air radial ;
- le deuxième dissipateur thermique comprend au moins un logement configuré pour loger en partie au moins une capacité de filtrage, la deuxième face d'échange thermique du deuxième dissipateur thermique comprenant ladite paroi de fond dudit au moins un logement. En d'autres termes, les capacités de filtrage sont logées dans un ou plusieurs logements. Éventuellement, une partie seulement des capacités de filtrage sont logées dans des logements, chaque logement logeant au moins une capacité de filtrage, et préférentiellement une seule ou deux capacités de filtrage ;
- l'au moins un logement du deuxième dissipateur thermique s'étend en saillie par rapport à la première face d'échange thermique et dans une direction opposée à la pluralité d'ailettes par rapport à ladite première face d'échange thermique. Cette configuration avantageuse permet de réduire une dimension du système de contrôle suivant un axe sensiblement perpendiculaire au module de commande, en permettant qu'une distance séparant le module de commande du module de puissance suivant ledit axe soit inférieure à une dimension longitudinale de la ou des capacités de filtrage. À cet effet, le module de commande comprend au moins une ouverture complémentaire afin de permettre aux logements du deuxième dissipateur thermique de s'étendre en leur centre ;

- chaque capacité de filtrage est logée dans un fourreau permettant d'isoler thermiquement la capacité de filtrage correspondante par rapport au premier dissipateur thermique, chaque fourreau étant ouvert au niveau d'une extrémité longitudinale située du côté de la face de dissipation de la capacité de filtrage correspondante. À cet effet, une dimension longitudinale de chaque fourreau est légèrement inférieure à une dimension longitudinale de la capacité de filtrage correspondante, la dimension longitudinale étant prise préférentiellement suivant un axe sensiblement perpendiculaire au module de commande. Chaque fourreau loge au moins une capacité de filtrage, et préférentiellement une seule ou deux capacités de filtrage ;
- dans un plan parallèle à la deuxième face d'échange thermique du deuxième dissipateur thermique, une dimension latérale de l'au moins un logement dudit deuxième dissipateur thermique est supérieure à une dimension latérale des fourreaux de la capacité de filtrage correspondante, de sorte que chaque fourreau soit inséré au moins partiellement dans l'un des au moins un logement correspondant ;
- un joint d'étanchéité, par exemple un joint colle, est situé entre une paroi latérale délimitant chaque logement et le fourreau correspondant de la capacité de filtrage. Cette configuration avantageuse permet de maintenir le fourreau logeant la capacité de filtrage à l'intérieur du logement correspondant du deuxième dissipateur thermique. Complémentairement, le joint d'étanchéité permet d'une part de maintenir en position la capacité de filtrage à l'intérieur de son logement, et/ou d'autre part de fermer hermétiquement le logement correspondant afin d'éviter que de l'eau et/ou de l'humidité ne s'infiltre à l'intérieur dudit logement ;
- la paroi latérale de l'au moins un logement ou le fourreau de la capacité de filtrage correspondante comprend une gorge périphérique configurée pour loger en partie le joint d'étanchéité ;
- le système de contrôle conforme au premier aspect de l'invention comprend au moins une entretoise s'étendant entre le premier dissipateur thermique et le deuxième dissipateur thermique afin de solidariser à distance ledit premier dissipateur thermique audit deuxième dissipateur thermique. Chaque entretoise est alternativement rapportée sur le premier dissipateur thermique ou issue de matière avec ledit premier dissipateur thermique. Cette configuration avantageuse permet d'une part de disposer la ou les capacités de filtrage entre le module de commande et le module de puissance, et d'autre part de permettre la circulation d'un flux d'air entre ledit module de commande et ledit module de puissance ;
- le premier dissipateur thermique comprend une première face de transfert thermique en contact thermique avec au moins une partie des composants électroniques du module de puissance. Le couplage thermique entre la première face de transfert thermique du premier dissipateur thermique et les composants électroniques du module de puissance est préférentiellement réalisé au niveau d'une face de couplage thermique du substrat métallique de chaque organe de puissance formant le module de puissance, lesdits substrats métalliques supportant les composants électroniques correspondants. Complémentairement, le premier dissipateur thermique comprend aussi une deuxième face de transfert thermique comprenant une pluralité d'ailettes qui s'étendent en saillie par rapport à ladite deuxième face de transfert thermique et dans une direction opposée au deuxième dissipateur thermique par rapport à la première face de transfert thermique. Le contact thermique de la première face de transfert thermique du premier dissipateur thermique avec le module de puissance permet de réaliser un couplage thermique entre la partie des composants électronique et le premier dissipateur thermique et de dissiper les calories produites par lesdits composants électroniques durant leur fonctionnement vers ledit premier dissipateur thermique. La présence des ailettes sur la deuxième face de transfert thermique du premier dissipateur thermique permet d'augmenter la surface d'échange thermique entre ledit premier dissipateur thermique et l'air ambiant. Cette configuration avantageuse permet d'améliorer les échanges thermiques entre le module de puissance et l'air ambiant ;
- le module de puissance est logé dans un espace délimité, selon une direction sensiblement perpendiculaire à la première face de transfert thermique du premier dissipateur thermique, par ladite première face de transfert thermique du premier dissipateur thermique et la deuxième face d'échange thermique du deuxième dissipateur thermique. En d'autres termes, le système de contrôle conforme au premier aspect de l'invention permet de définir un espace de ventilation entre le premier et le deuxième dissipateur thermique afin de favoriser les échanges thermiques avec l'air ambiant, et consécutivement d'améliorer le refroidissement du module de commande et du module de puissance ;
- le système de contrôle conforme au premier aspect de l'invention comprend une ouverture centrale qui s'étend entre le module de commande et le premier dissipateur thermique. Cette configuration avantageuse permet d'améliorer une circulation de l'air ambiant entre les différents composants du système de contrôle et, finalement, d'améliorer d'une part les échanges thermiques avec l'air ambiant et d'autre part l'efficacité des premier et deuxième dissipateurs thermiques. En particulier, en fonction de la configuration du système de contrôle, le module de commande comprend une ouverture centrale, et/ou le module de puissance comprend une ouverture centrale, et/ou le premier dissipateur thermique comprend une ouverture centrale, et/ou le deuxième dissipateur thermique comprend une ouverture centrale et/ou le boitier comprend une ouverture centrale.
- le système de contrôle conforme au premier aspect de l'invention comprend un couvercle de fermeture fixé solidairement au boitier. Avantageusement, le couvercle de fermeture s'étend au-delà des logements du deuxième dissipateur thermique par rapport au module de commande. En d'autres termes, les logements du deuxième dissipateur thermique sont situés dans un espace délimité notamment par la module de commande d'une part et le couvercle de fermeture d'autre part. Il existe un jeu non nul entre le couvercle de fermeture et une extrémité distale des logements du deuxième dissipateur thermique par rapport au module de commande ;
- de manière avantageuse, le couvercle de fermeture prend la forme d'une plaque. En particulier, et contrairement à l'art antérieur connu jusqu'alors, le couvercle de fermeture ne comprend pas d'éléments structurels permettant d'augmenter sa surface d'échange avec l'air ambiant : le couvercle de fermeture est ici simplifié et ne joue plus un rôle de dissipateur thermique comme auparavant.

Selon un deuxième aspect de l'invention, il est proposé un ensemble électrique comprenant une machine électrique tournante et un système de contrôle conforme au premier aspect de l'invention ou selon l'un quelconque de ses perfectionnements afin de piloter la machine électrique tournante.

De manière avantageuse, la machine électrique de l'ensemble électrique conforme au deuxième aspect de l'invention s'étend au-delà du premier dissipateur thermique du système de contrôle par rapport audit système de contrôle, ledit premier dissipateur thermique étant situé dans une position intermédiaire entre la machine électrique tournante et le deuxième dissipateur thermique du système de contrôle.

Cette configuration avantageuse permet de refroidir plus efficacement le module de puissance, le module de commande et surtout les capacités de filtrage du système de contrôle. En effet, la disposition particulièrement avantageuse du deuxième dissipateur thermique le rend exposé à un flux d'air radial circulant dans l'espace délimité par les deux dissipateurs thermiques du système de contrôle, comme exposé précédemment. Ce flux d'air est notamment généré par la rotation de la machine électrique tournante qui entraine l'air ambiant par l'ouverture centrale et au travers de l'espace délimité par les deux dissipateurs thermiques. Consécutivement, l'efficacité du refroidissement est accrue et la durée de vie de l'au moins une capacité de filtrage est accrue, réduisant ainsi les risques de panne de l'ensemble électrique conforme au deuxième aspect de l'invention.

Des modes de réalisation variés de l'invention sont prévus, intégrant selon l'ensemble de leurs combinaisons possibles les différentes caractéristiques optionnelles exposées ici.

### Description des figures

D'autres caractéristiques et avantages de l'invention apparaîtront encore au travers de la description qui suit d'une part, et de plusieurs exemples de réalisation donnés à titre indicatif et non limitatif en référence aux dessins schématiques annexés d'autre part, sur lesquels :
- la FIGURE 1 illustre une vue en perspective d'un exemple de réalisation d'un ensemble électrique conforme au conforme au deuxième aspect de l'invention ;
- la FIGURE 2A illustre une vue en perspective tronquée selon un plan transversal d'un système de contrôle de l'ensemble électrique illustré sur la FIGURE 1 ;
- la FIGURE 2B illustre une vue de détail du module de puissance du système de contrôle de l'ensemble électrique illustré sur la FIGURE 1 ;
- la FIGURE 3 illustre une vue en perspective tronquée d'une partie supérieure du système de contrôle et mettant en évidence le deuxième dissipateur thermique au niveau du boitier du module de commande de l'ensemble électrique illustré sur la FIGURE 1 ;
- la FIGURE 4 illustre une vue en perspective d'une face supérieure du deuxième dissipateur thermique illustré sur la FIGURE 3 ; et
- la FIGURE 5 illustre une vue de dessous du deuxième dissipateur thermique illustré sur la FIGURE 4.

Bien entendu, les caractéristiques, les variantes et les différentes formes de réalisation de l'invention peuvent être associées les unes avec les autres, selon diverses combinaisons, dans la mesure où elles ne sont pas incompatibles ou exclusives les unes des autres. On pourra notamment imaginer des variantes de l'invention ne comprenant qu'une sélection de caractéristiques décrites par la suite de manière isolées des autres caractéristiques décrites, si cette sélection de caractéristiques est suffisante pour conférer un avantage technique ou pour différencier l'invention par rapport à l'état de la technique antérieur.

En particulier toutes les variantes et tous les modes de réalisation décrits sont combinables entre eux si rien ne s'oppose à cette combinaison sur le plan technique.

Sur les figures, les éléments communs à plusieurs figures conservent la même référence.

### Description détaillée de l'invention

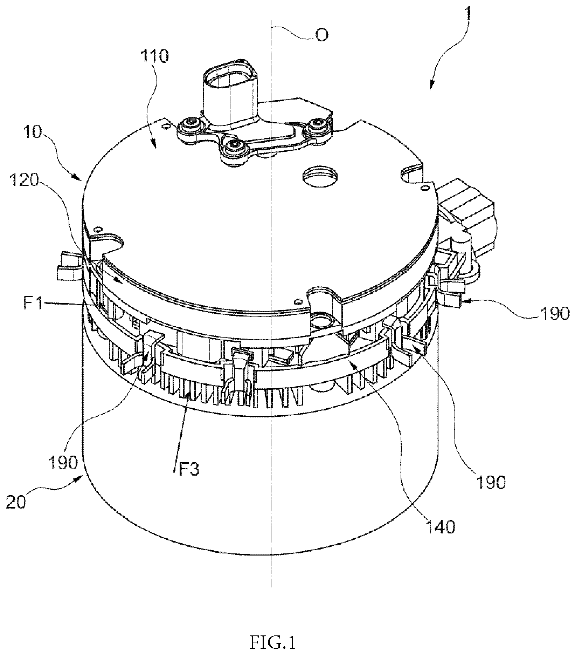

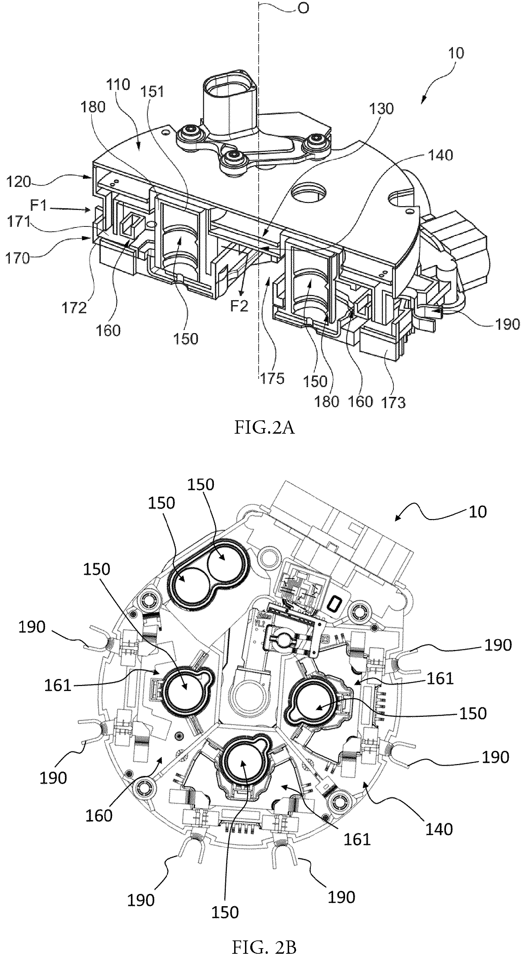

En référence aux FIGURES 1 et 2, un exemple de réalisation d'un ensemble électrique 1 conforme au conforme au deuxième aspect de l'invention est décrit.

L'ensemble électrique 1 comprend une machine électrique tournante 20 et un système de contrôle 10 conforme au premier aspect de l'invention afin de piloter la machine électrique tournante 20. L'ensemble électrique 1 est par exemple destiné à être alimenté par un réseau de bord d'un véhicule automobile.

Dans l'exemple illustré sur la FIGURE 1, la machine électrique tournante 20 est représentée de manière schématique et elle ne sera pas décrite en détail dans les paragraphes qui suivent. Le long d'un axe de rotation O situé au centre de l'ensemble électrique 1 et s'étendant de manière sensiblement verticale sur les FIGURES, la machine électrique tournante 20 est fixée solidairement au système de contrôle 10 par des moyens de fixation non représentés ; et elle est située en-dessous dudit système de contrôle 10.

Les FIGURES illustrent un exemple particulier du système de contrôle 10 conforme au premier aspect de l'invention. Un tel système de contrôle comprend :
- un module de puissance 160 connecté électriquement à une machine électrique tournante, afin par exemple de générer au moins un signal électrique de puissance destiné à alimenter une phase électrique d'un stator de la machine électrique tournante 20 lorsque ladite machine électrique tournante 20 est utilisée comme moteur ;
- un module de commande 130 permettant de générer au moins un signal de commande afin de piloter le module de puissance 160. Le module de commande 130 est logé dans un boitier 120 ;
- au moins une capacité de filtrage 150 permettant de filtrer le courant échangé entre le module de puissance 160 et le réseau de bord. Dans l'exemple illustré sur les FIGURES, le système de contrôle 10 comprend cinq capacités de filtrage 150 ;
- dans cet exemple de réalisation un filtre en pi contenant deux des cinq capacités de filtrage 150 est placé entre le module de puissance et le réseau de bord ;
- un premier dissipateur thermique 170 associé au module de puissance 160 et permettant de réaliser un transfert thermique des calories générées par le module de puissance 160 durant son fonctionnement vers un air ambiant entourant le système de contrôle 10 ;
- un deuxième dissipateur thermique 140 associé au module de commande 130 et permettant de réaliser un transfert thermique des calories générées par le module de commande 130 durant son fonctionnement avec l'air ambiant entourant le système de contrôle 10. Conformément à l'invention, le deuxième dissipateur thermique est aussi en couplage thermique avec chaque capacité de filtrage 150 afin de réaliser un transfert thermique des calories générées par chaque capacité de filtrage 150 avec l'air ambiant entourant le système de contrôle 10.

Plus particulièrement, le système de contrôle 10 a une forme générale cylindrique et selon un contour fermé globalement circulaire. À son extrémité supérieure, le système de contrôle est fermé par un couvercle de fermeture 110 fermant le module de commande. De manière avantageuse, le couvercle 110 prend la forme d'une plaque circulaire fixée solidairement sur le boitier 120, notamment au niveau d'un pourtour périphérique extérieur formant un rebord 121.

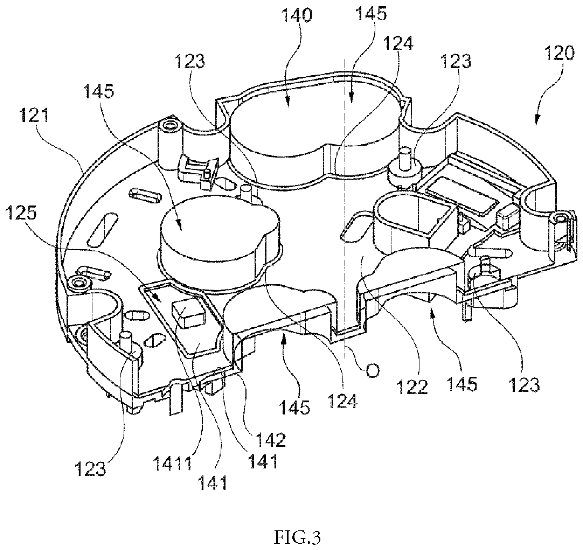

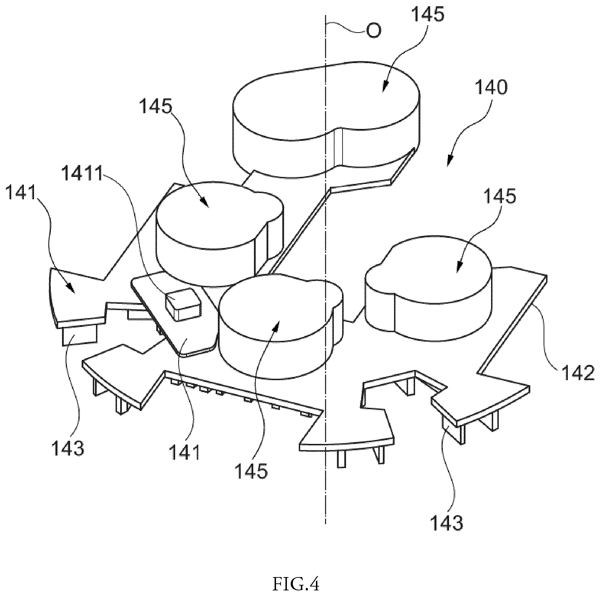

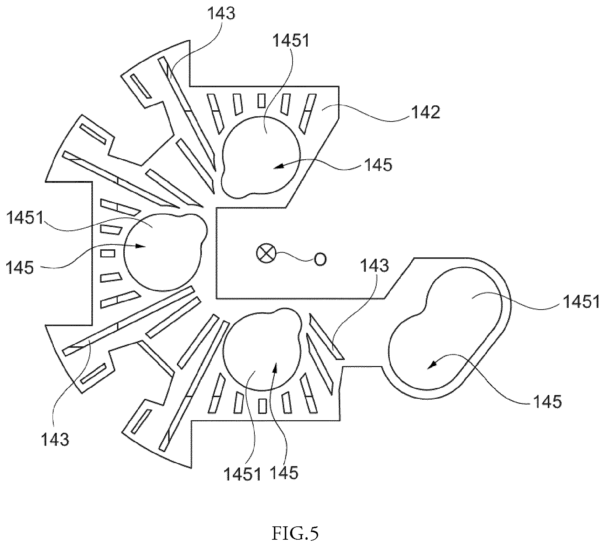

En référence à la FIGURE 3, le boitier 120 est délimité en périphérie par le rebord 121 de forme globalement circulaire et qui s'étend en saillie au-delà d'une plaque de fond 122 dudit boitier 120. Ainsi, la plaque de fond 122 et le rebord 121 forment collectivement un volume à l'intérieur duquel il est possible de loger le module de commande 130, visible uniquement sur la FIGURE 1. Plus particulièrement, le boitier 120 comprend une pluralité d'entretoises 123 permettant de placer ledit module de commande 130 dans une position axialement intermédiaire entre la plaque de fond 122 et le couvercle de fermeture 110, prise le long de l'axe de rotation O. Le boitier 120 comprend aussi une pluralité de premières ouvertures 124 à l'intérieur desquelles s'étendent en partie des logements 145 du deuxième dissipateur thermique qui sera décrit plus en détail en référence aux FIGURES 4 et 5.

Enfin, le boitier 120 comprend aussi une deuxième ouverture 125 qui permet de réaliser un couplage thermique direct entre le deuxième dissipateur thermique 140 et le module de commande 130. Plus particulièrement, la deuxième ouverture 125 du boitier 120 s'étend avantageusement autour d'une partie du module de commande 130 qui est majoritairement génératrice de chaleur durant son fonctionnement. À titre d'exemple non limitatif, il peut s'agir par exemple de composants électroniques actifs, tels que par exemple des transistors. Complémentairement, la deuxième ouverture 125 du boiter 120 s'étend aussi autour d'un plot 1411 du deuxième dissipateur thermique 140, ledit plot 1411 s'étendant en saillie depuis une première face d'échange thermique 141 du deuxième dissipateur thermique 140. Le plot 1411 fait partie de la première face d'échange thermique 141 du deuxième dissipateur thermique 140. Le plot 1411 est avantageusement situé à l'aplomb de la partie du module de commande 130 qui est majoritairement génératrice de chaleur durant son fonctionnement et décrite précédemment. Ainsi, une face supérieure du plot 1411 est en appui contre une face inférieure du module de commande 130, réalisant ainsi un couplage thermique direct afin d'extraire des calories générées par les composants électroniques dudit module de commande 130 et d'éviter une élévation de température qui serait nuisible au bon fonctionnement du module de commande 130.

À titre d'exemple non limitatif, le boitier 120 peut être réalisé dans un matériau métallique ou dans un matériau plastique. Dans ce dernier cas, il est préférable que les dissipateurs thermiques soient au moins en partie surmoulés par le boitier 120.

Afin de garantir un fonctionnement optimal du module de puissance 160, et notamment des commutateurs utilisés pour former un pont de puissance tel que décrit précédemment, le système de contrôle 10 décrit sur la FIGURE 2A comprend une pluralité de capacités de filtrage 150.

En fonction des puissances électriques générées par le module de puissance 160, les capacités de filtrage 150 ont des dimensions qui les rendent encombrantes et/ou difficilement intégrable dans le système de contrôle 10. À titre d'exemple non limitatif, une dimension longitudinale d'une des capacités de filtrage est supérieure ou égale à 15 mm, voire supérieure à 30 mm.

Les capacités de filtrage 150 ont généralement une forme cylindrique avec une base circulaire. La dimension longitudinale correspond à la distance séparant deux flasques circulaires fermant la capacité de filtrage.

Chaque capacité de filtrage 150 a un diamètre qui est généralement compris entre 5 et 21 mm.

Les capacités de filtrage 150 du système de contrôle 10 peuvent être identiques ou différentes en fonction des besoins de filtrage recherchés. En particulier, chaque capacité de filtrage présente généralement une valeur qui est généralement supérieure à 500 µF.

À titre d'exemple non limitatif, les capacités de filtrage 150 sont du type d'un condensateur chimique.

Comme décrit précédemment, les capacités de filtrages 150 sont fermées à chaque extrémité longitudinale par un flasque circulaire : un premier flasque circulaire permet d'établir une connexion électrique avec le module de puissance 160, par l'intermédiaire d'une pluralité de broches électriques ; et un deuxième flasque circulaire forme une face de dissipation 151 par laquelle les calories sont dissipées lors du fonctionnement de ladite capacité de filtrage 150. À tire d'exemple, au moins la moitié, voire au moins les trois-quarts des calories produites par la capacité de filtrage 150 durant son fonctionnement sont dissipées au niveau de la face de dissipation.

Le module de puissance 160 illustré sur les FIGUREs 2A et 2B prend la forme d'une pluralité d'organes de puissance 161, chaque organe de puissance comportant des composants électroniques en couplage électrique avec un substrat métallique, préférentiellement du type d'une barre omnibus 190 permettant de relier électriquement chaque organe de puissance du module de puissance 160 à la machine électrique tournante 20. En particulier, chaque organe de puissance formant le module de puissance 160 est alimenté par deux barres omnibus basse tension permettant de relier électriquement le module de puissance 160 au réseau électrique. Préférentiellement, chaque barre omnibus basse tension permet de transporter respectivement une première tension de +48V et une deuxième tension de -48V.

Complémentairement, chaque organe de puissance est relié électriquement aux phases électriques de la machine électrique tournante 20 par la barre omnibus 190 afin de transporter des signaux haute tension, dits de puissance, vers ou depuis la machine électrique tournante 20.

En d'autres termes, chaque organe de puissance du module de puissance 160 est équipé (i) d'un substrat métallique formé par un barreau de cuivre ou d'une barre omnibus par exemple, ledit substrat métallique supportant notamment des transistors de puissance (ii) de deux connexions de puissance, reliées électriquement à la machine électrique tournante 20, et par l'intermédiaire desquelles les phases électriques sont transportées entre l'organe de puissance correspondant et ladite machine électrique tournante 20, et (iii) de deux barres omnibus basse tension permettant d'interfacer le module de puissance avec le réseau électrique.

Chaque organe de puissance du module de puissance 160 comprend avantageusement un pont de puissance formé par au moins une paire de transistors de puissance pilotés comme des commutateurs entre un état de conduction passant et un état de conduction bloquant, la barre omnibus 190 de chaque organe de puissance étant reliée électriquement à un point intermédiaire situé entre les deux transistors de puissance.

De manière avantageuse, les transistors de puissance du module de puissance 160 sont du type transistor à effet de champ à structure métal-oxyde-semiconducteur (MOSFET, acronyme anglais pour « *Metal Oxyde Semiconductor Field Effect Transistor* »)*.*

De manière avantageuse, une face du module de puissance 160 est en couplage thermique avec le premier dissipateur thermique 170 afin d'extraire les calories générées par les transistors de puissance durant son fonctionnement. Plus particulièrement, chaque substrat métallique de chaque organe de puissance formant le module de puissance 160 est situé au-dessus du premier dissipateur thermique 170, de sorte que ledit module de puissance 160 se trouve dans une position axialement intermédiaire entre le premier dissipateur thermique 170 et le deuxième dissipateur thermique 140, par rapport à l'axe de rotation O. De manière avantageuse, le premier dissipateur thermique 170 est couplé thermiquement au module de puissance 160 par l'intermédiaire d'une patte thermique ou d'une colle thermique.

À cet effet, le système de contrôle 10 illustré sur les FIGURES comprend au moins une entretoise s'étendant entre le premier dissipateur thermique 170 et le deuxième dissipateur thermique 140 afin de solidariser à distance ledit premier dissipateur thermique 170 audit deuxième dissipateur thermique 140 et de permettre d'une part de loger le module de puissance 160, et d'autre part d'insérer les capacités de filtrage 150 entre ledit premier dissipateur thermique 170 et ledit deuxième dissipateur thermique 140. Cette configuration avantageuse permet aussi d'améliorer la circulation d'un flux d'air à l'intérieur du système de contrôle 10 lorsque la machine électrique tournante 20 est en fonctionnement et, consécutivement, d'améliorer l'efficacité du premier dissipateur thermique 170 et du deuxième dissipateur thermique 140, tel qu'il sera décrit ultérieurement.

Le premier dissipateur thermique 170 comprend une première face de transfert thermique 171 en contact thermique avec une face du module de puissance 160, et une deuxième face de transfert thermique 172 comprenant une pluralité d'ailettes 173 qui s'étendent en saillie par rapport à ladite deuxième face de transfert thermique et dans une direction opposée au deuxième dissipateur thermique 140 par rapport à la première face de transfert thermique 171. En d'autres termes, les ailettes 173 du premier dissipateur thermique 170 s'étendent vers le bas, c'est-à-dire en direction de la machine électrique tournante 20.

Le premier dissipateur thermique 170 comprend avantageusement une ouverture centrale 175 afin de permettre d'améliorer la circulation d'un flux d'air à l'intérieur du système de contrôle 10 lorsque la machine électrique tournante 20 est en fonctionnement et, consécutivement, d'améliorer l'efficacité le refroidissement du module de puissance 160 en collaboration avec le premier dissipateur thermique 170, tel qu'il sera décrit ultérieurement.

Le premier dissipateur thermique 170 est avantageusement formé dans un matériau à fort coefficient de conductivité thermique afin de favoriser les transferts thermiques par conduction avec le module de puissance 160. À titre d'exemple non limitatif, le premier dissipateur thermique 170 peut être formé dans un matériau métallique, tel que comprenant de l'aluminium et/ou un alliage d'aluminium et/ou du cuivre et/ou du magnésium.

Comme visible sur la FIGURE 2A, le deuxième dissipateur thermique 140 est situé à proximité du module de commande 130 afin de dissiper les calories produites par ledit module de commande 130 durant son fonctionnement. Tel que décrit précédemment, le deuxième dissipateur thermique 140 comprend une plaque de base dont une première face d'échange thermique 141 est en contact thermique avec au moins une partie des composants électroniques du module de commande 130. Selon une première variante de réalisation, le couplage thermique entre la première face d'échange thermique 141 et l'au moins une partie des composants électroniques du module de commande 130 est direct, notamment par l'intermédiaire du plot décrit précédemment. Selon une deuxième variante de réalisation, le couplage thermique entre la première face d'échange thermique 141 et l'au moins une partie des composants électroniques du module de commande 130 est indirect, ledit couplage thermique étant réalisé par l'intermédiaire d'une patte thermique disposée entre ladite première face d'échange thermique 141 et l'au moins une partie des composants électroniques du module de commande 130. Complémentairement, le deuxième dissipateur thermique 140 comprend aussi une deuxième face d'échange thermique 142 formée par une pluralité d'ailettes 143 qui s'étendent en saillie par rapport à ladite deuxième face d'échange thermique 142 et dans une direction opposée à la première face d'échange 141 par rapport à la deuxième face d'échange thermique 142. Cette configuration avantageuse permet d'augmenter la surface d'échange avec l'air ambiant et, consécutivement, d'améliorer l'efficacité du refroidissement du module de commande 130.

Comme visible sur la FIGURE 5, chaque ailette 143 du deuxième dissipateur thermique 140 s'étend longitudinalement selon une direction radiale par rapport à l'axe de rotation O de la machine électrique tournante 20. L'axe de rotation O de la machine électrique tournante 20 correspond aussi à un axe central du système de contrôle 10. Cette configuration avantageuse permet de favoriser l'écoulement d'un flux d'air depuis la périphérie extérieure du système de contrôle 10 et vers une région centrale située à proximité de l'axe de rotation O.

Conformément à l'invention selon son premier aspect, le deuxième dissipateur thermique 140 est en couplage thermique avec chaque capacité de filtrage 150 afin de réaliser un transfert thermique des calories générées par ladite au moins une capacité de filtrage 150 avec l'air ambiant. Plus particulièrement, la face de dissipation 151 de chaque capacité de filtrage 150 est en contact thermique avec une face de couplage thermique du deuxième dissipateur thermique 140 et située en regard de ladite face de dissipation 151. Selon une première variante de réalisation, le couplage thermique entre la face de dissipation 151 de chaque capacité de filtrage 150 et la face de couplage thermique du deuxième dissipateur thermique 140 située en regard de ladite face de dissipation 151 est direct. Selon une deuxième variante de réalisation, le couplage thermique entre la face de dissipation 151 de chaque capacité de filtrage 150 et la face de couplage thermique du deuxième dissipateur thermique 140 située en regard de ladite face de dissipation 151 est indirect, ledit couplage thermique étant réalisé par l'intermédiaire d'une patte thermique ou une colle thermique disposée entre ladite entre la face de dissipation 151 de chaque capacité de filtrage 150 et ladite face de couplage thermique du deuxième dissipateur thermique 140. Compte tenu de l'intégration des capacités de filtrage 150 dans le système de contrôle 10, la face de couplage thermique du deuxième dissipateur thermique 140 correspond à la deuxième face d'échange thermique 142 de sa plaque de base.

Compte tenu des dimensions longitudinales importantes des capacités de filtrage, et afin de limiter les dimensions axiales du système de contrôle 10 conforme au premier aspect de l'invention, le deuxième dissipateur thermique 140 comprend aussi une pluralité de logements 145 afin de loger en partie chaque capacité de filtrage 150, la face de couplage thermique du deuxième dissipateur thermique 140 étant formée par une paroi de fond 1451 dudit au moins un logement 145, comme visible sur les FIGURES 2, 4 et 5. Chaque logement accueille une seule capacité de filtrage 150 ou deux capacités de filtrage 150.

Afin d'empêcher l'infiltration d'eau ou d'humidité à proximité des capacités de filtrage 150 et/ou d'isoler thermiquement et/ou électriquement les parois latérales de chaque capacité de filtrage 150, notamment par rapport au premier dissipateur thermique 170, chaque capacité de filtrage 150 est placée dans un fourreau 180. Le fourreau a une forme générale cylindrique, dont une première extrémité longitudinale est fermée du côté du premier dissipateur thermique 170 - tout en permettant d'établir les connexions électriques avec le module de puissance 160 tel que décrit précédemment - et dont une deuxième extrémité longitudinale est ouverte du côté de la face de dissipation 151 de la capacité de filtrage 150 correspondante. En partant de la première extrémité longitudinale du fourreau 180, une paroi latérale du fourreau 180 s'étend en direction de la face de dissipation 151 de la capacité de filtrage, mais la face de dissipation 151 de la capacité de filtrage demeure au-delà de la deuxième extrémité du fourreau 180 lorsque ladite capacité de filtrage 150 est logée dans ledit fourreau 180. Cette configuration avantageuse permet d'établir un contact thermique entre la face de dissipation 151 de la capacité de filtrage 150 avec la paroi de fond 1451 du logement correspondant 145, sans préjudice de la présence du fourreau 180.

Les fourreaux 180 de chaque capacité de filtrage 150 sont avantageusement en matière plastique. En variante, les fourreaux 180 peuvent également être réalisés en métal, en particulier lorsque ces fourreaux sont des extensions du premier dissipateur 170.

Afin de permettre un couplage thermique entre le deuxième dissipateur 140 thermique et les capacités de filtrage 150, chaque logement 145 dudit deuxième dissipateur thermique 140 est configuré pour loger une extrémité longitudinale supérieure de la capacité de filtrage 150 correspondante, c'est-à-dire l'extrémité longitudinale située du côté du deuxième dissipateur thermique 140 et comprenant la face de dissipation 151. Ainsi, chaque logement 145 est délimité par un contour fermé de forme globalement circulaire lorsque le logement 145 accueille une seule capacité 150. Les dimensions latérales de chaque logement 145 sont supérieures au diamètre de la capacité de filtrage 150 accueillie et de son fourreau 180.

Afin d'améliorer le maintien de la capacité de filtrage 150 et de son fourreau 180 dans le logement 145 du deuxième dissipateur thermique 140, un joint colle peut être placé entre le fourreau 180 et son logement 145. Éventuellement, une gorge périphérique est réalisée sur la paroi latérale du logement 145 et/ou sur la paroi extérieure du fourreau 180 afin de loger le joint colle.

En fonctionnement, un rotor de la machine électrique 20 tournante est entrainé en rotation par un champ magnétique généré au niveau de son stator, du fait des signaux électriques de puissance générés par le module de puissance 160. Le rotor de la machine électrique tournante 20 porte notamment un ventilateur dont une orientation des pales permet d'aspirer l'air ambiant lorsque le ventilateur tourne autour de l'axe de rotation O.

Plus particulièrement, l'air ambiant est aspiré par le volume libre situé entre le premier dissipateur thermique 170 et le deuxième dissipateur thermique 140, et représenté par la flèche F1 sur la FIGURE 2A. Cette aspiration d'air F1 génère un flux d'air concentrique depuis les zones périphériques extérieures du système de contrôle F1 jusqu'à une zone située à proximité de l'axe de rotation O : le flux d'air aspiré F1 suit des conduits radiants et convergents vers l'axe de rotation, délimités par les ailettes 143 du deuxième dissipateur thermique 140. Ce mouvement d'air convergent permet de favoriser les échanges thermiques du deuxième dissipateur thermique 140 avec le flux d'air F1 aspiré. Consécutivement, le refroidissement des capacités de filtrage 150 est amélioré.

Lorsque le flux d'air aspiré F1 arrive au niveau de la région centrale située à proximité de l'axe de rotation O, il est aspiré en direction de la machine électrique tournante 20 située en contrebas. Ce flux d'air réorienté en direction de la machine électrique tournante 20 est référencé F2 sur la FIGURE 2A.

À cet effet, le système de contrôle 10 conforme au premier aspect de l'invention comprend une ouverture centrale 175 qui s'étend axialement entre le module de commande 130 et le premier dissipateur thermique 170. Plus particulièrement, les différents composants du système de contrôle ont, s'ils s'étendent à proximité de l'axe de rotation O, une telle ouverture centrale 175 afin de permettre au flux d'air aspiré F1 d'être réorienté en direction de la machine électrique tournante 20. Ainsi, dans l'exemple illustré sur les FIGURES, le module de puissance 160, le premier dissipateur thermique 170 et le deuxième dissipateur thermique 140 comprennent une telle ouverture centrale 175.

De manière analogue, lorsque le ventilateur est entrainé en rotation par la machine électrique tournante 20, l'air ambiant situé en périphérie du système de contrôle 10 est aussi aspiré par le volume libre situé entre le premier dissipateur thermique 170 et la partie supérieure la machine électrique tournante 20, et représenté par la flèche F3 sur la FIGURE 1. Cette seconde aspiration d'air F3 génère un flux d'air concentrique depuis les zones périphériques extérieures du système de contrôle jusqu'à une zone située à proximité de l'axe de rotation O : le second flux d'air aspiré F3 suit des conduits radiants et convergents vers l'axe de rotation O, délimités par les ailettes 173 du premier dissipateur thermique 170. Ce mouvement d'air convergent permet de favoriser les échanges thermiques du premier dissipateur thermique 170 avec le second flux d'air F3 aspiré. Consécutivement, le refroidissement du module de puissance 160 est amélioré.

Lorsque le second flux d'air aspiré F3 arrive au niveau de la région centrale située à proximité de l'axe de rotation O, il est réorienté en direction de la machine électrique tournante 20 située en contrebas.

En synthèse, l'invention concerne notamment une configuration astucieuse pour un système de contrôle permettant de piloter une machine électrique tournante 20, ledit système de contrôle 10 comprenant un module de puissance 160 et un module de commande 130, chaque module de puissance 160 et module de commande 130 étant régulé thermiquement par respectivement un premier 170 et un deuxième 140 dissipateur thermique. Le deuxième dissipateur thermique 140 comprend des logements 145 qui permettent de coupler thermiquement les capacités de filtrage 150 du système de contrôle 10 et d'améliorer leur refroidissement, en soumettant le deuxième dissipateur thermique 140 à un flux d'air concentrique et convergent F1 vers la région centrale proche de l'axe de rotation O de la machine électrique tournante 20.

Bien sûr, l'invention n'est pas limitée aux exemples qui viennent d'être décrits et de nombreux aménagements peuvent être apportés à ces exemples sans sortir du cadre de l'invention. Notamment, les différentes caractéristiques, formes, variantes et modes de réalisation de l'invention peuvent être associées les unes avec les autres selon diverses combinaisons dans la mesure où elles ne sont pas incompatibles ou exclusives les unes des autres. En particulier toutes les variantes et modes de réalisation décrits précédemment sont combinables entre eux.

## Revendications

1. Système de contrôle (10) comprenant :
- un module de puissance (160) électriquement connectable à une machine électrique tournante (20) ;
- un module de commande (130) configuré pour générer au moins un signal de commande permettant de piloter le module de puissance (160), ledit module de commande (130) étant logé dans un boitier (120) ;
- un premier dissipateur thermique (170) associé au module de puissance (160), ledit premier dissipateur thermique (170) étant configuré pour réaliser un transfert thermique des calories générées par le module de puissance (160) durant son fonctionnement avec un air ambiant ;
- un deuxième dissipateur thermique (140) associé au module de commande (130), ledit deuxième dissipateur thermique (140) étant configuré pour réaliser un transfert thermique des calories générées par le module de commande (130) durant son fonctionnement avec l'air ambiant ;
- au moins une capacité de filtrage (150) électriquement reliée au module de puissance (160), et insérée entre ledit premier dissipateur thermique (170) et ledit deuxième dissipateur thermique (140) ;
**caractérisé en ce qu'**il comprend également au moins une entretoise s'étendant entre le premier dissipateur thermique (170) et le deuxième dissipateur thermique (140) afin de solidariser à distance ledit premier dissipateur thermique (170) audit deuxième dissipateur thermique (140),
et **en ce que** le module de puissance (160) est situé au-dessus du premier dissipateur thermique (170), de sorte que ledit module de puissance (160) se trouve dans une position axialement intermédiaire entre le premier dissipateur thermique (170) et le deuxième dissipateur thermique (140), par rapport à un axe de rotation O,
et le deuxième dissipateur thermique (140) comprend au moins un logement (145) configuré pour loger en partie ladite au moins une capacité de filtrage et qui permet de coupler thermiquement le deuxième dissipateur thermique (140) et la capacité de filtrage (150) afin de réaliser un transfert thermique des calories générées par ladite au moins une capacité de filtrage (150) avec l'air ambiant.

2. Système de contrôle (10) selon la revendication précédente, dans lequel chaque au moins une capacité de filtrage (150) comprend une face de dissipation (151) en contact thermique avec une face de couplage thermique du deuxième dissipateur thermique (140) et située en regard de ladite face de dissipation (151).

3. Système de contrôle (10) selon la revendication 2, dans lequel le deuxième dissipateur thermique (140) comprend une plaque de base dont :
- une première face d'échange thermique (141) est en contact thermique avec au moins une partie des composants électroniques du module de commande (130) ;
- une deuxième face d'échange thermique (142) comprend une pluralité d'ailettes (143) qui s'étendent en saillie par rapport à ladite deuxième face d'échange thermique (142) et dans une direction opposée à la première face d'échange thermique (141) par rapport à la deuxième face d'échange thermique (142).

4. Système de contrôle (10) selon la revendication précédente, dans lequel, dans un plan parallèle à la deuxième face d'échange thermique (142), chaque ailette (143) du deuxième dissipateur thermique (140) s'étend longitudinalement selon une direction radiale par rapport à un axe central (O) du système de contrôle (10), ledit axe central (O) s'étendant perpendiculairement à la deuxième face d'échange thermique (142).

5. Système de contrôle (10) selon l'une quelconque des revendications 3 ou 4, dans, la deuxième face d'échange thermique (142) du deuxième dissipateur thermique (140) comprenant la paroi de fond (1451) dudit au moins un logement (145).

6. Système de contrôle (10) selon la revendication précédente, dans lequel l'au moins un logement (145) du deuxième dissipateur thermique (140) s'étend en saillie par rapport à la première face d'échange thermique (141) et dans une direction opposée à la pluralité d'ailettes (143) par rapport à ladite première face d'échange thermique (141).

7. Système de contrôle (10) selon l'une quelconque des revendications 5 ou 6, dans lequel chaque capacité de filtrage (150) est logée dans un fourreau (180) permettant d'isoler thermiquement la capacité de filtrage (150) correspondante par rapport au premier dissipateur thermique (170), chaque fourreau (180) étant ouvert au niveau d'une extrémité longitudinale située du côté de la face de dissipation (151) de la capacité de filtrage (150) correspondante.

8. Système de contrôle (10) selon la revendication précédente, dans lequel, dans un plan parallèle à la deuxième face d'échange thermique (142) du deuxième dissipateur thermique (140), une dimension latérale de l'au moins un logement (145) dudit deuxième dissipateur thermique (140) est supérieure à une dimension latérale des fourreaux (180) de la capacité de filtrage (150) correspondante, de sorte que chaque fourreau (180) soit inséré au moins partiellement dans l'un des au moins un logement (145) correspondant.

9. Système de contrôle (10) selon la revendication 1, dans lequel le premier dissipateur thermique (170) comprend :
- une première face de transfert thermique (171), en contact thermique avec au moins une partie des composants électroniques du module de puissance (160) ;
- une deuxième face de transfert thermique (172) comprenant une pluralité d'ailettes (173) qui s'étendent en saillie par rapport à ladite deuxième face de transfert thermique (172) et dans une direction opposée au deuxième dissipateur thermique (140) par rapport à la première face de transfert thermique (171).

10. Système de contrôle (10) selon l'une quelconque des revendications précédentes, dans lequel le module de puissance (160) est logé dans un espace délimité, selon une direction sensiblement perpendiculaire à la première face de transfert thermique (171) du premier dissipateur thermique (170), par ladite première face de transfert thermique (171) du premier dissipateur thermique (170) et la deuxième face d'échange thermique (142) du deuxième dissipateur thermique (140).

11. Ensemble électrique comprenant :
- une machine électrique tournante (20) ;
- un système de contrôle (10) selon l'une quelconque des revendications précédentes afin de piloter la machine électrique tournante (20).

## Patentansprüche

1. Steuerungssystem (10), umfassend:
- ein Leistungsmodul (160), das elektrisch mit einer rotierenden elektrischen Maschine (20) verbindbar ist;
- ein Steuermodul (130), das konfiguriert ist, um mindestens ein Steuersignal zur Ansteuerung des Leistungsmoduls (160) zu erzeugen, wobei das Steuermodul (130) in einem Gehäuse (120) untergebracht ist;
- einen ersten Kühlkörper (170), der dem Leistungsmodul (160) zugeordnet ist, wobei der erste Kühlkörper (170) konfiguriert ist, um eine Wärmeübertragung der vom Leistungsmodul (160) während seines Betriebs erzeugten Wärme an die Umgebungsluft zu bewirken;
- einen zweiten Kühlkörper (140), der dem Steuermodul (130) zugeordnet ist, wobei der zweite Kühlkörper (140) konfiguriert ist, um eine Wärmeübertragung der vom Steuermodul (130) während seines Betriebs erzeugten Wärme an die Umgebungsluft zu bewirken;
- mindestens eine Filterkapazität (150), die elektrisch mit dem Leistungsmodul (160) verbunden und zwischen dem ersten Kühlkörper (170) und dem zweiten Kühlkörper (140) eingefügt ist;
**dadurch gekennzeichnet, dass** es außerdem mindestens einen Abstandshalter umfasst, der sich zwischen dem ersten Kühlkörper (170) und dem zweiten Kühlkörper (140) erstreckt, um den ersten Kühlkörper (170) mit dem zweiten Kühlkörper (140) auf Distanz fest zu verbinden,
und dass das Leistungsmodul (160) oberhalb des ersten Kühlkörpers (170) angeordnet ist, so dass sich das Leistungsmodul (160) in einer axial intermediären Position zwischen dem ersten Kühlkörper (170) und dem zweiten Kühlkörper (140) befindet, bezogen auf eine Rotationsachse O,
und der zweite Kühlkörper (140) mindestens eine Aufnahme (145) umfasst, die konfiguriert ist, um die mindestens eine Filterkapazität teilweise aufzunehmen, und die eine thermische Kopplung des zweiten Kühlkörpers (140) und der Filterkapazität (150) ermöglicht, um eine Wärmeübertragung der von der mindestens einen Filterkapazität (150) erzeugten Wärme an die Umgebungsluft zu bewirken.

2. Steuerungssystem (10) nach dem vorhergehenden Anspruch, bei dem jede mindestens eine Filterkapazität (150) eine Ableitfläche (151) umfasst, die in thermischem Kontakt mit einer thermischen Kopplungsfläche des zweiten Kühlkörpers (140) steht und dieser Ableitfläche (151) gegenüberliegt.

3. Steuerungssystem (10) nach Anspruch 2, bei dem der zweite Kühlkörper (140) eine Grundplatte umfasst, deren:
- eine erste Wärmeaustauschfläche (141) in thermischem Kontakt mit mindestens einem Teil der elektronischen Komponenten des Steuermoduls (130 steht);
- eine zweite Wärmeaustauschfläche (142) eine Vielzahl von Lamellen (143) umfasst, die sich von der zweiten Wärmeaustauschfläche (142) vorstehend und in einer Richtung entgegengesetzt zur ersten Wärmeaustauschfläche (141) bezogen auf die zweite Wärmeaustauschfläche (142) erstrecken.

4. Steuerungssystem (10) nach dem vorhergehenden Anspruch, bei dem sich in einer Ebene parallel zur zweiten Wärmeaustauschfläche (142) jede Lamelle (143) des zweiten Kühlkörpers (140) longitudinal in einer radialen Richtung bezogen auf eine Mittelachse (O) des Steuerungssystems (10) erstreckt, wobei sich die Mittelachse (O) senkrecht zur zweiten Wärmeaustauschfläche (142) erstreckt.

5. Steuerungssystem (10) nach einem der Ansprüche 3 oder 4, bei dem die zweite Wärmeaustauschfläche (142) des zweiten Kühlkörpers (140) die Bodenwand (1451) der mindestens einen Aufnahme (145) umfasst.

6. Steuerungssystem (10) nach dem vorhergehenden Anspruch, bei dem sich die mindestens eine Aufnahme (145) des zweiten Kühlkörpers (140) von der ersten Wärmeaustauschfläche (141) vorstehend und in einer Richtung entgegengesetzt zur Vielzahl von Lamellen (143) bezogen auf die erste Wärmeaustauschfläche (141) erstreckt.

7. Steuerungssystem (10) nach einem der Ansprüche 5 oder 6, bei dem jede Filterkapazität (150) in einer Hülse (180) untergebracht ist, die es ermöglicht, die entsprechende Filterkapazität (150) thermisch von dem ersten Kühlkörper (170) zu isolieren, wobei jede Hülse (180) an einem longitudinalen Ende offen ist, das sich auf der Seite der Ableitfläche (151) der entsprechenden Filterkapazität (150) befindet.

8. Steuerungssystem (10) nach dem vorhergehenden Anspruch, bei dem in einer Ebene parallel zur zweiten Wärmeaustauschfläche (142) des zweiten Kühlkörpers (140) eine Seitenabmessung der mindestens einen Aufnahme (145) des zweiten Kühlkörpers (140) größer ist als eine Seitenabmessung der Hülsen (180) der entsprechenden Filterkapazität (150), so dass jede Hülse (180) zumindest teilweise in eine der mindestens einen entsprechenden Aufnahme (145) eingesetzt ist.

9. Steuerungssystem (10) nach Anspruch 1, bei dem der erste Kühlkörper (170) umfasst:
- eine erste Wärmeübertragungsfläche (171), die in thermischem Kontakt mit mindestens einem Teil der elektronischen Komponenten des Leistungsmoduls (160 steht);
- eine zweite Wärmeübertragungsfläche (172), die eine Vielzahl von Lamellen (173) umfasst, die sich von der zweiten Wärmeübertragungsfläche (172) vorstehend und in einer Richtung entgegengesetzt zum zweiten Kühlkörper (140) bezogen auf die erste Wärmeübertragungsfläche (171) erstrecken.

10. Steuerungssystem (10) nach einem der vorhergehenden Ansprüche, bei dem das Leistungsmodul (160) in einem Raum untergebracht ist, der, in einer Richtung im Wesentlichen senkrecht zur ersten Wärmeübertragungsfläche (171) des ersten Kühlkörpers (170), durch die erste Wärmeübertragungsfläche (171) des ersten Kühlkörpers (170) und die zweite Wärmeaustauschfläche (142) des zweiten Kühlkörpers (140) begrenzt wird.

11. Elektrische Baugruppe, umfassend:
- eine rotierende elektrische Maschine (20);
- ein Steuerungssystem (10) nach einem der vorhergehenden Ansprüche zur Ansteuerung der rotierenden elektrischen Maschine (20).

## Claims

1. A control system (10) comprising:
- a power module (160) electrically connectable to a rotating electrical machine (20);
- a control module (130) configured to generate at least one control signal for controlling the power module (160), said control module (130) being housed in a casing (120);
- a first heat sink (170) associated with the power module (160), said first heat sink (170) being configured to perform a thermal transfer of calories generated by the power module (160) during its operation with ambient air;
- a second heat sink (140) associated with the control module (130), said second heat sink (140) being configured to perform a thermal transfer of calories generated by the control module (130) during its operation with ambient air;
- at least one filtering capacitor (150) electrically connected to the power module (160), and inserted between said first heat sink (170) and said second heat sink (140);
**characterized in that** it also comprises at least one spacer extending between the first heat sink (170) and the second heat sink (140) to rigidly connect said first heat sink (170) to said second heat sink (140) at a distance,
and **in that** the power module (160) is located above the first heat sink (170), so that said power module (160) is in an axially intermediate position between the first heat sink (170) and the second heat sink (140), relative to an axis of rotation O,
and the second heat sink (140) comprises at least one housing (145) configured to partially house said at least one filtering capacitor and which allows for thermal coupling of the second heat sink (140) and the filtering capacitor (150) in order to perform a thermal transfer of calories generated by said at least one filtering capacitor (150) with ambient air.

2. A control system (10) according to the preceding claim, wherein each at least one filtering capacitor (150) comprises a dissipation face (151) in thermal contact with a thermal coupling face of the second heat sink (140) and located opposite said dissipation face (151).

3. A control system (10) according to claim 2, wherein the second heat sink (140) comprises a base plate of which:
- a first heat exchange face (141) is in thermal contact with at least a part of the electronic components of the control module (130);
- a second heat exchange face (142) comprises a plurality of fins (143) which extend in protrusion from said second heat exchange face (142) and in a direction opposite to the first heat exchange face (141) relative to the second heat exchange face (142).

4. A control system (10) according to the preceding claim, wherein, in a plane parallel to the second heat exchange face (142), each fin (143) of the second heat sink (140) extends longitudinally in a radial direction relative to a central axis (O) of the control system (10), said central axis (O) extending perpendicularly to the second heat exchange face (142).

5. A control system (10) according to any one of claims 3 or 4, wherein the second heat exchange face (142) of the second heat sink (140) comprises the bottom wall (1451) of said at least one housing (145).

6. A control system (10) according to the preceding claim, wherein the at least one housing (145) of the second heat sink (140) extends in protrusion from the first heat exchange face (141) and in a direction opposite to the plurality of fins (143) relative to said first heat exchange face (141).

7. A control system (10) according to any one of claims 5 or 6, wherein each filtering capacitor (150) is housed in a sleeve (180) allowing to thermally isolate the corresponding filtering capacitor (150) from the first heat sink (170), each sleeve (180) being open at a longitudinal end located on the side of the dissipation face (151) of the corresponding filtering capacitor (150).

8. A control system (10) according to the preceding claim, wherein, in a plane parallel to the second heat exchange face (142) of the second heat sink (140), a lateral dimension of the at least one housing (145) of said second heat sink (140) is greater than a lateral dimension of the sleeves (180) of the corresponding filtering capacitor (150), so that each sleeve (180) is at least partially inserted into one of the at least one corresponding housing (145).

9. A control system (10) according to claim 1, wherein the first heat sink (170) comprises:
- a first thermal transfer face (171), in thermal contact with at least a part of the electronic components of the power module (160);
- a second thermal transfer face (172) comprising a plurality of fins (173) which extend in protrusion from said second thermal transfer face (172) and in a direction opposite to the second heat sink (140) relative to the first thermal transfer face (171).

10. A control system (10) according to any one of the preceding claims, wherein the power module (160) is housed in a space delimited, in a direction substantially perpendicular to the first thermal transfer face (171) of the first heat sink (170), by said first thermal transfer face (171) of the first heat sink (170) and the second heat exchange face (142) of the second heat sink (140).

11. An electrical assembly comprising:
- a rotating electrical machine (20);
- a control system (10) according to any one of the preceding claims for controlling the rotating electrical machine (20).
